# EUROPEAN PATENT SPECIFICATION

(11) **EP 0 240 305 B1**
(45) Date of publication and mention of the grant of the patent: **20.01.1993**
(21) Application number: 87302781.7
(22) Date of filing: 31.03.1987
(51) Int. Cl.: H01L 21/205, C23C 16/24

(54) **Method for forming a deposited film**
Herstellungsverfahren einer niedergeschlagenen Schicht
Méthode de fabrication d'une couche déposée

(30) Priority: 31.03.1986 JP 73093/86; 20.03.1987 JP 67334/87
(43) Date of publication of application: 07.10.1987
(73) Proprietor: CANON KABUSHIKI KAISHA, Tokyo (JP)
(72) Inventor: Matsuyama, Jinsho, Nagahama-shi Shiga-ken (JP); Hirai, Yutaka, Hikone-shi Shiga-ken (JP); Ueki, Masao, Urayasu-shi§Chiba-ken (JP); Sakai, Akira, Nagahama-shi Shiga-ken (JP)
(74) Representative: Beresford, Keith Denis Lewis

(56) References cited:
- EP-A- 0 240 306
- EP-A- 0 240 314
- EP-A- 0 241 204
- FR-A- 2 292 517
- GB-A- 2 162 206
- PATENT ABSTRACTS OF JAPAN, vol. 8, no. 172 (C-237)[1609], 09 August1984; & JP-A-59 69 495
- PATENT ABSTRACTS OF JAPAN, vol. 10, no. 99 (E-396)[2156], 16 April 1986; & JP-A-60 241 222

## Description

### BACKGROUND OF THE INVENTION

### Field of the Invention

This invention relates to a method for formation of a deposited film useful for obtaining a functional film, particularly a semiconductive film which is useful for electronic devices such as semiconductor device, optical input sensor device for an optical image inputting apparatus, photosensitive device for electrophotography, etc.

### Related Background Art

In the prior art, for formation of functional films, particularly crystalline semiconductor films, suitable film forming methods have been individually employed from the standpoint of desired physical characteristics, uses, etc.

For example, for formation of silicon deposited films such as of amorphous or polycrystalline, i.e. non-single crystalline, silicon which are optionally compensated for lone pair electrons with a compensating agent such as hydrogen atoms (H) or halogen atoms (X), etc., (hereinafter abbreviated as "NON-Si (H,X)", particularly "A-Si (H,X)" when indicating amorphous silicon and "poly-Si (H,X)" when indicating polycrystalline silicon) (the so-called microcrystalline silicon is included within the category of A-Si (H,X) as a matter of course), there have been employed the vacuum vapor deposition method, the plasma CVD method, the thermal CVD method, the reactive sputtering method, the ion plating method, the optical CVD method, etc. Generally, the plasma CVD method has been widely used and industrialized.

However, the reaction process in formation of a silicon deposited film according to the plasma CVD method which has been generalized in the prior art is considerably complicated as compared with the conventional CVD method, and its reaction mechanism involves not a few unclarified points. Also, there exist a large number of parameters for formation of a deposited film such as substrate temperature, flow rate and flow rate ratio of gases to be introduced, pressure during formation, high frequency power, electrode structure, structure of a reaction vessel, speed of evacuation, plasma generating system, etc. By use of a combination of such a large number of parameters, plasma may sometimes become unstable state, whereby marked deleterious influences were exerted frequently on a deposited film formed. Besides, parameters characteristic of film forming devices must be selected for each device and therefore under the present situation it has been difficult to generalize the production condition.

Also, in the case of the plasma CVD method, since plasma is directly generated by high frequency or microwave, etc., in a film forming space in which a substrate on which film is to be formed is placed, electrons or a number of ion species generated thereby may give damages to the film in the film forming process to cause lowering in film quality or non-uniformization of film quality. Moreover, the condition suitable for crystallization of a deposited film is restricted and therefore it has been deemed to be difficult to produce a polycrystalline deposited film with stable characteristics.

On the other hand, for formation of an epitaxial deposited film such as of silicon, germanium, group II-VI or Group III-V semiconductors, etc., there have been used the gas phase epitaxy and the liquid phase epitaxy as defined in a broad sense (generally speaking, the strict definition of epitaxy is to grow another single crystal on a single crystal, both having the same single crystal axes, but here epitaxy is interpreted in a broader sense and it is not limited to the growth onto a single crystal substrate).

The liquid phase epitaxy is a method for precipitating a semiconductor crystal on a substrate by dissolving a starting material for semiconductor at high temperature to a super-saturated state in a solvent metal which is molten to a liquid and cooling the solution. According to this method, since crystals are grown under a state most approximate to thermal equilibrium among various epitaxy techniques, crystals with high perfectness can be obtained, but on the other hand, bulk productivity is poor and surface state is bad. For such reasons, in an optical device which requires an epitaxial layer which is thin and also uniform in thickness, problems are accompanied such as yield in device production, or influences exerted on device characteristics, etc., and therefore this method is not frequently used.

On the other hand, the gas phase epitaxy has been attempted by physical methods such as the vacuum vapor deposition method, the sputtering method, etc., or chemical methods such as hydrogen reduction of a metal chloride or otherwise thermal pyrolysis of a metal organic compound or a metal hydride. Among them, the molecular beam epitaxy which is a kind of the vacuum vapor deposition method is a dry process under ultra-high vacuum, and therefore high purification and low temperature growth of crystals are possible, whereby there is the advantage that composition and concentration can be well controlled to give a relatively flat deposited film. However, in addition to an enormous cost required for a film forming device, the surface defect density is great, and no effective method for controlling directionality of molecular beam has been developed, and also enlargement of area is difficult and bulk productivity is not so high. Due to such many problems, it has not been industrialized yet.

The hydrogen reduction method of a metal chloride or the thermal pyrolysis method of a metal organic compound or a metal hydride are generally called the halide CVD method, the hydride CVD method, MO-CVD method. For these methods, by the reason that a film forming device can be made with relative ease and also as the starting materials, i.e. metal chloride, metal hydrides and organic metals, those with high purities are now readily available, they have been studied widely at the present time and application for various devices has been investigated.

However, in these methods, it is required to heat a substrate to a high temperature at which reduction reaction or thermal pyrolysis reaction can occur and therefore the scope of substrate material to be selected is limited, and also contamination with impurities such as carbon or halogen, etc., is liable to cause if decomposition of starting material is insufficient, thus having the drawback that controllability of doping is poor. Also while, depending on the application use of a deposited film, it is desired to effect bulk production with reproducibility with full satisfaction in terms of enlargement of area, uniformization of film thickness as well as uniformness of film quality and yet at a high speed film formation, under the present situation no technique which enables bulk production with maintaining practical characteristics satisfying the above demands has been established yet.

The present invention is directed to a solution of the problem of providing a crystalline film having uniform characteristics over a large area and exhibiting satisfactory semiconductive characteristics. It is directed to a process which is conservative in the expenditure of energy and which also is suited to simple process control.

In accordance with the present invention there is provided a method for forming crystalline film on the surface of a substrate, which method comprises:
introducing a first gaseous material into a film forming space containing the substrate, and adsorbing an amount of said first gaseous material at the surface of said substrate;
removing a surplus amount of said first gaseous material while retaining a sufficient amount of said first gaseous material adsorbed at the surface of said substrate;
introducing a second gaseous material into said film forming space and reacting this with said sufficient amount of said first-gaseous material adsorbed at the surface of said substrate to form the crystalline film; and
which method is characterised in that:
the surface of said substrate either has, provided at the outset, at scattered sites thereof, a multiplicity of single-crystalline grains for seeding growth of the crystalline film or has regions which differ in their respective propensity for nucleating film material for growth of the crystalline film;
the first and second gaseous materials are one and the other of:
a gaseous starting material containing a major constituent of the film to be formed, and
a gaseous halogenic oxidising agent having the property of oxidative action on said gaseous starting material; and
flow rates of said first and second gaseous materials and temperatures and pressures during adsorption and reaction are appropriately chosen such that said reacting of said first and second gaseous materials results in the growth of film in a poly-crystalline form.

In the prior art technique of plasma CVD, spurious etching and/or abnormal discharge can arise during film formation. Since in this present method the deposited film is formed by a reaction with a gaseous halogenic oxidizing agent, such deleterious effects are obviated.

This method for forming deposited film, which utilizes a redox reaction of a gaseous starting material (I) containing an element which is to become a major constituent element of the deposited film, with a gaseous halogenic oxidizing agent (II), thus requires no high temperature for deposition. Accordingly there is no disturbance of the film structure by heat. No heating installation is required for production and none of the expense of running the same is incurred. The film therefore can be made at a lower cost.

Also it becomes possible to select the substrate material from a wide range of materials, since this choice is not dictated by the heat resistant properties of the material chosen as hitherto.

Since the present method relies upon adsorption and surface reaction enlargement of area is possible and is not restricted to specific shapes and sizes of substrate. In general, the starting materials employed need only be introduced in small amounts. Accordingly, the film forming space can be chosen smaller and the yield can be improved dramatically.

Also, in this method of forming deposited film the sizes of the crystal grains can be preselected according to the arrangement of the nuclei for crystal growth on the substrate. A crystalline deposited film having chosen characteristics can be deposited at any desired region of the substrate.

To summarise, energy saving during formation of deposited film can be effected and at the same time management of film quality can be easily done, whereby it becomes possible to form a good crystalline deposited film having uniform film quality and characteristics over a large area. Further, it is possible to obtain efficiently a crystalline film which is excellent in productivity and mass productivity, of high quality and also excellent in various characteristics such as electrical, optical, semiconductive characteristics, etc.

### BRIEF DESCRIPTION OF THE DRAWINGS

Fig. 1 is a schematic illustration of the film forming device used in Examples of the present invention.

Fig. 2 shows an embodiment of the film forming steps according to the present invention.

Fig. 3 shows an another embodiment of the film forming steps according to the present invention.

Fig. 4 shows a further embodiment of the film forming steps according to the present invention.

### DESCRIPTION OF THE PREFERRED EMBODIMENT

In the method for forming a deposited film of the present invention, the gaseous starting material to be used for formation of a deposited film (hereinafter called "gaseous starting material (I)") is a material to be subjected to oxidation action through contact with the gaseous halogenic oxidizing agent (hereinafter called "halogenic oxidizing agent (II)"), and may be selected suitably as desired depending on the kind, characteristic, use, etc., of a deposited film to be desired. In the method of the present invention, the above gaseous starting material (I) and the halogenic oxidizing agent (II) are gaseous when introduced, but may be gaseous, liquid or solid under an ordinary state. In the case when the gaseous starting material (I) or the halogenic oxidizing agent (II) is liquid or solid under an ordinary state, a carrier gas such as Ar, He, N₂, H₂, etc., is used to effect bubbling, optionally with heating, and thereby introduce the gaseous starting material (I) or the halogenic oxidizing agent (II) in a gaseous state into a film forming space to form an adsorbed layer on a substrate, and then the other material is introduced in a gaseous state.

During this operation, the introducing pressure of the above gaseous starting material (I) or the halogenic oxidising agent (II) may be set by controlling the flow rate of the carrier gas or the vapor pressure of the gaseous starting material (I) or the halogenic oxidizing agent (II). When the gaseous starting material (I) or the halogenic oxidising agent (II) is a gas under an ordinary state, it can be also introduced as diluted with a carrier gas such as Ar, He, N₂, H₂, etc., if necessary.

As the gaseous starting material (I) to be used in the method of the present invention, for obtaining a deposited film of e.g. silicon belonging to the group IV of the periodic table, there may be employed straight and branched chain silane compounds, cyclic silane compounds, etc.

Specifically as the gaseous starting material (I), examples of the straight chain silane compounds may include SiₙH₂ₙ₊₂ (n = 1, 2, 3, 4, 5, 6, 7 or 8), examples of the branched chain silane compounds SiH₃SiH(SiH₃)SiH₂SiH₃, and examples of cyclic silane compounds SiₙH₂ₙ (n = 3, 4, 5 or 6), etc.

The halogenic oxidizing agent (II) to be used in the method of the present invention is gaseous when introduced into the film forming space and at the same time has the property of exerting oxidation action effectively on the gaseous starting material (I) for formation of a deposited film merely through contact therewith. Halogenic gases such as F₂, Cl₂, Br₂, I₂, ClF, etc., for example, are effective.

Either one of these gaseous starting material (I) and halogenic oxidizing agent (II) is first introduced in the form of a gas with desired flow rate and feeding pressure into a film forming space in which a substrate for formation of deposited film is arranged to form an adsorbed layer on said substrate, and then the other is introduced after a desired time with a desired flow rate and feeding pressure, whereby the both are collided against each other on the surface of the above adsorbed layer to cause a surface chemical reaction, whereby the above halogenic oxidizing agent (II) exerts oxidation reaction on the above gaseous starting material (I) to form a deposited film on the substrate having a material which becomes the crystal nuclei for a deposited film to be formed or a material capable of forming selectively crystal nuclei scatteringly on the surface. Such deposited film forming process can proceed with better efficiency and with more saving of energy, whereby a deposited film having desired good physical characteristics over the whole film surface can be formed at a lower substrate temperature than hitherto.

So that the deposited film forming process may proceed smoothly and a film having desired physical characteristics of high quality may be formed, as the film forming factors, the kinds and combination of the starting material (I) for formation of deposited film and the halogenic oxidizing agent (II), the pressure during reaction, the flow rate, the inner pressure of the film forming space, the kind of the substrate, the pressure during adsorption, the flow pattern of the gases, the adsorption temperature and the film forming temperature (substrate temperature and atmosphere temperature) are selected as appropriate. These film forming factors are inter-related, and therefore they are not determined in isolation but are determined collectively. The process of adsorption and reaction of the gaseous starting material (I) for formation of a deposited film and the gaseous halogenic oxidizing agent (II) to be introduced into the film forming space may be determined as appropriate and in relation to the film forming factors mentioned above.

In adsorption of gas molecules onto a solid surface, there exists intramolecular force, and the chemical adsorption with valence energy is greater in its intramolecular force than the physical adsorption with dispersion energy (corresponding to Van der Waals force).

Also, while physical adsorption is liable to become a multi-layer adsorption, a chemical adsorption is a monomolecular layer adsorption. Therefore preferably for controlling deposition of a homogeneous thin film, chemical adsorption is preferred.

However, physical adsorption and chemical adsorption of gas molecules may be considered to be inter-related in a complicated way and the form of adsorption is not necessarily limited. On the other hand, the factors which determine the adsorption state may include the kind of adsorbed molecules, the kind of solid surface and the surface state, and further temperature and pressure as controlling factors, and it is at least necessary to determine these controlling factors so that the reaction may be carried out to give a desired deposited film.

That is to say, if the pressure in the vacuum chamber is too low in the course from adsorption to reaction, desorption from the state of physical adsorption is liable to occur, while if the temperature is too high, dissociating adsorption from the state of chemical adsorption is liable to occur. The reaction process therefore must be selected with care.

In one cycle for formation of a deposited film, the forming of an adsorbed layer and the reacting of the adsorbed layer with the starting material, prior to uniform formation of a deposited film on the substrate surface can be performed by the following steps. There is a step of introducing the starting material A into the film forming space and permitting it in a suitable amount adsorbed on the substrate to form an adsorbed layer. (A first step; step (A)) and there is further a step of permitting the adsorbed layer of the starting material A to remain while discharging superfluous starting material A (a second step). In these steps, the pressures may be set suitably for the above reasons, and the pressure in the first step may be preferably higher for sufficient progress of adsorption, preferably 1.3 x 10⁻⁵ to 1.3 x 10³ Pa (1 x 10⁻⁷ to 10 Torr), more preferably 1.3 x 10⁻² to 1.3 x 10² Pa (1 x 10⁻⁴ to 1 Torr).

The pressure in the second step may be preferably lower for discharging superfluous starting material A, preferably 1.3 x 10⁻⁸ to 1.3 x 10² Pa (1 x 10⁻¹⁰ to 1 Torr), more preferably 1.3 x 10⁻⁷ to 1.3 Pa (1 x 10⁻⁹ to 1 x 10⁻² Torr).

Further, one cycle for formation of a deposited film may comprise subsequent to these steps a step of introducing the starting material B to cause the surface reaction with the adsorbed layer on the substrate to form the deposited film (a third step; step (B)), and next a step of discharging by-products formed other than the deposited film at this time (a fourth step), and the pressure during the reaction in the third step may be preferably higher in order to enhance the probability of contact between the starting materials A and B, but the final value is determined suitably as desired in view of reactivity.

The pressure in the third step may be preferably 1.3 x 10⁻⁶ to 1.3 x 10³ Pa (1 x 10⁻⁸ to 10 Torr), more preferably 1.3 x 10⁻⁴ to 1.3 x 10² Pa (1 x 10⁻⁶ to 1 Torr).

The pressure in the fourth step may be preferably 1.3 x 10⁻¹⁰ to 1.3 x 10² Pa (1 x 10⁻¹² to 1 Torr).

In the method thus far described, the said steps (A) and (B) are conducted at least once, and depending on the case, steps (A) and (B) may be repeated in this order as required. In that case,the time required for each step (A) or (B) may be constant or varied for each cycle.

For forming selectively a desired crystalline deposited film, crystal nuclei for the deposited film to be formed or regions of a material capable of supporting selective nucleation nuclei are provided these being regularly or irregularly scattered on the substrate surface.

In the former case, by arrangement of single crystalline grains on the substrate, a crystal can be selectively grown with the single crystalline grains becoming crystal nuclei.

Also, by selecting suitably the film forming conditions and the kind of crystalline material which become crystal nuclei, crystalline deposited films of different kinds can be selectively formed.

In the case of the latter, by utilizing the difference in nuclei formation density of the depositing material according to the kinds of the materials of the deposited surface, by arranging a different kind of material from the material of the substrate surface scatteringly with a desired pattern on the substrate, a desired crystalline deposited film can be formed selectively.

As the substrate to be used in the former case, a substrate with small growth of silicon crystals having silicon single crystal grains arranged thereon may be employed. Further, in place of the silicon crystal as described above, crystals different in kind from silicon may be also used as the nuclei, but the materials of these crystals are required to satisfy the following conditions.
1. The lattice constant of the crystalline material on the substrate surface should be identical to or very nearly to the lattice constant of the deposited film.
2. The coefficients of thermal expansion of the crystalline material on the substrate surface and the deposited film should be identical with or very nearly the same as each other.

Hence, as the material which would constitute the surface of a suitable substrate for obtaining a deposited film of e.g. crystalline Si, there may be used CaF₂, ZnS, Yb, Mn₃Ga, NaCoF₃, Ni₃Sn, Fe₃C, NiTeₓ (x < 0.7), CoMnO₃, NiMnO₃, CuCl, AlP, Si, etc.

Further, even when the above two conditions are barely met by selecting the deposition conditions more adequately, a crystalline deposited film can be also obtained, and the present invention is not limited only to the materials described above.

As the substrate to be used in the latter case, for example, those having Si₃N₄ arranged scatteringly on SiO₂ film or those having SiO₂ covering Si₃N₄ film having part of the underlying Si₃N₄ exposed, may be employed.

These substrates utilize the property of silicon crystal nuclei which are formed with ease on Si₃N₄ and with difficulty on SiO₂, and in the method for forming a deposited film of the present invention, both amorphous and crystalline materials can be used, provided they have difference in difficulty and easiness in supporting the formation of nuclei.

The substrate temperature (Ts) during film formation may be set as appropriate depending on the kind of the deposited film to be formed and the kind of the substrate used.

The method of the present invention will now be considered in more detail with reference to examples. This is by way of illustration only and it is not intended that the invention should be limited by these examples.

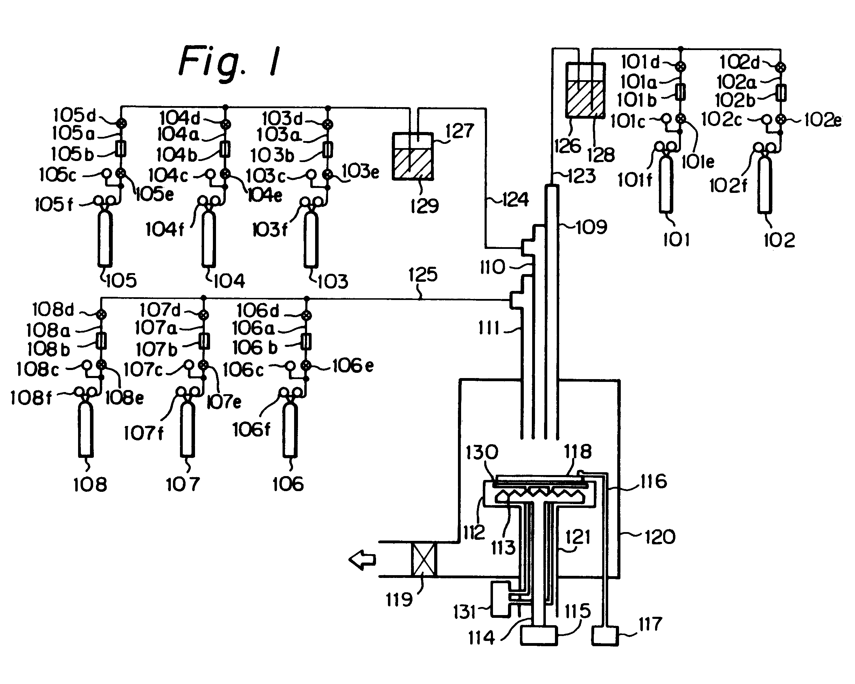

Fig. 1 shows one example of a preferred apparatus for performing the method for formation of a deposited film of the present invention.

The device for forming a deposited film shown in Fig. 1 is classified broadly into the three parts: the main device; the discharging system; and the gas feeding system.

The main device is provided with a film forming space.

101 to 108 are respectively bombs filled with the gases to be used during film formation, 101a-108a are respectively gas feeding pipes, 101b-108b are respectively mass flow controllers for controlling the flow rates of the gases from the respective bombs, 101c-108c are respectively gas pressure gauges, 101d-108d and 101e-108e are respectively valves, and 101f-108f are respectively pressure gauges indicating the pressures in the corresponding gas bombs.

120 is a vacuum chamber, having a structure such that a pipeline for introduction of gas is provided at the upper portion and a reaction space is formed downstream of the pipeline, and also having a structure such that a film forming space provided with a substrate holder 112 may be formed so that a substrate 118 may be placed as opposed to the gas introducing inlet of said pipeline. The pipeline for introduction of gas has a three-arrangement structure, having from the innerside a first gas introducing pipe 109 for introducing gases for the gas bombs 101, 102, a second gas introducing pipe 110 for introducing the gases from the gas bombs 103-105, and a third gas introducing pipe 111 for introducing the gases from the gas bombs 106-108.

Feeding of the gases from the bombs to the respective introducing pipes is done through the gas feeding pipelines 123-125, respectively.

The respective gas introducing pipes, the respective gas feeding pipelines and the vacuum chamber 120 are evacuated to vacuum by a vacuum evacuating device not shown through the main vacuum valve 119.

The substrate 118 can be set freely at any desired position relative to the respective gas introducing pipes by moving the substrate holder 112 vertically and in the directions of X and Y.

The distance between the substrate and the gas introducing inlet of the gas introducing pipe may be determined appropriately in view of the kinds of the deposited film to be formed, its desired characteristics, gas flow rates, the inner pressure of the vacuum chamber, etc., but it should preferably several mm to 20 cm, more preferably about 5 mm to 15 cm.

130 is a cooling pipe for making the gas molecules of the starting material A easily adsorbable onto the substrate 118, and it is connected to the flow rate controller 131. Cooling can be also used during film formation or after film formation other than in the first and the second steps in which adsorption is effected.

113 is a heater for heating the substrate, which heats the substrate 118 to an appropriate temperature during film formation, preheats the substrate 118 before film formation, and further, after film formation, heats the film for annealing.

To the heater for heating the substrate 113 is fed power from the power source 115 through the wire 114.

116 is a thermocouple for measuring the temperature of the substrate (Ts) and is connected electrically to the temperature display device 117.

126 and 127 are bubblers for liquid starting materials, and used with filling of liquid starting materials for formation of a deposited film 128 and 129. When the starting materials for formation of a deposited film are gases under an ordinary state, it is not necessary to use bubblers for liquid starting materials.

### Example 1

By means of the film forming device shown in Fig. 1, a deposited film according to the method of the present invention was prepared as described below.

SiH₄ gas filled in the bomb 101 was fed at a flow rate of 40 sccm through the gas introducing pipe 109, F₂ gas filled in the bomb 106 at a flow rate of 60 sccm and the He gas filled in the bomb 107 at a flow rate 120 sccm through the gas introducing pipe 111 into the vacuum chamber 120. In this Example, the bubblers 126 and 127 for liquid starting materials were not used.

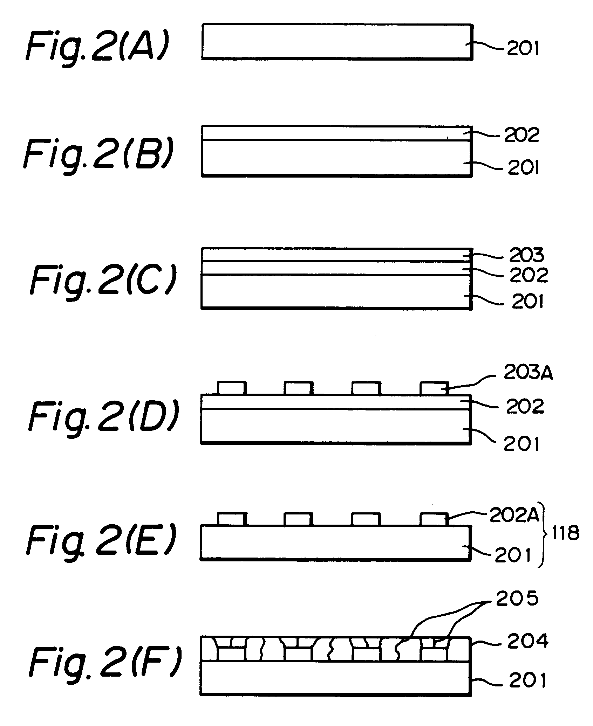

The substrate 118 was prepared according to the steps shown in Fig. 2.

First, a polycrystalline silicon substrate 201 as shown in Fig. 2(A) was washed, and subsequently silicon oxide thin film 202 was deposited on the whole surface of the substrate 1 according to the sputtering method (in this step other various thin film depositing methods such as vacuum vapor deposition, plasma discharging, MBE, CVD, etc., may be employed) (Figure 2(B)).

Subsequently, an electron beam resist layer 203 was formed on the thin film 202 (Figure 2(C)), and the electron beam resist layer 203 exposed to light by use of a photomask with a desired pattern and the electron beam resist layer 203 was partially removed by development (Figure 2(D)).

With the use of the remaining electron beam resist 203A as the mask, the silicon oxide thin film 202 was subjected to etching to form a thin film 202A with a desired pattern (Figure 2(E)).

According to the steps as described above, a substrate 118 with the crystal faces where a poly-crystalline silicon exists were exposed at constant intervals from the silicon oxide film was obtained. The domains of the silicon crystal exposed on the substrate surface were 50 nm (500 Å) in width, with intervals of 300 µm therebetween.

Next, the vacuum chamber 120 was evacuated under sufficient baking by means of an evacuating device not shown to 7 x 10⁻⁷Pa (5 x 10⁻⁹ Torr). SiH₄ gas filled in the bomb 101 was permitted to flow at a flow rate of 4 sccm through the gas introducing pipe 109 into the vacuum chamber 120 for 0.3 sec under the state maintained at an evacuating speed of 10⁻² Pa/cm (0.1 m Torr/cm) by controlling the evacuating valve 119. Subsequently, the valve 101d was closed to stop feeding of SiH₄ gas, and the state controlled to a vacuum degree of 1.3 Pa (0.01 Torr) by opening the evacuating valve 119 was maintained for 2 sec.

F₂ gas (diluted to 10% with He) filled in the bomb 107 was introduced at 4 sccm through the gas introducing pipe 111 into the vacuum chamber 120. The evacuation rate at this time was controlled to 10⁻¹ Pa (0.8 m Torr/sec) by controlling the evacuating valve 119, and after this state was maintained for 5 sec, the valve 107a was closed to stop feeding of F₂ gas, and the state controlled to a vacuum degree of 5 x 10⁻¹ Pa (0.004 Torr) by opening the evacuation valve 119 was maintained for 3 sec.

By repeating the operation as described above for 4200 times, a crystalline silicon deposited film 204 with a thickness of about 460 nm (4600 Å) was obtained.

Fig. 2(F) shows schematically the cross-section of the crystalline silicon deposited film 204 obtained on the substrate 118. 205 denotes grain boundaries in Fig. 2(F).

Further, by the use of the respective samples obtained, crystallinity of the deposited films was evaluated by the X-ray diffraction method and the electron beam diffraction method, whereby they were confirmed to be polycrystalline films. Further, the grain size of the polycrystalline silicon was found to be about 250 ±20 µm. Variance in crystal grain sizes was uniform over the whole surface of the substrate.

When the surface state of the samples was observed by a scanning type electron microscope, the smoothness was good without wavy pattern, etc., and the film thickness irregularity t was ±4 % or less. Also, the mobility and conductivity of the crystalline Si deposited film of the obtained samples was measured by the Van der Pauw method to be 250 (cm/V sec), 5 x 10⁻⁵ (S cm⁻¹), respectively.

### Example 2

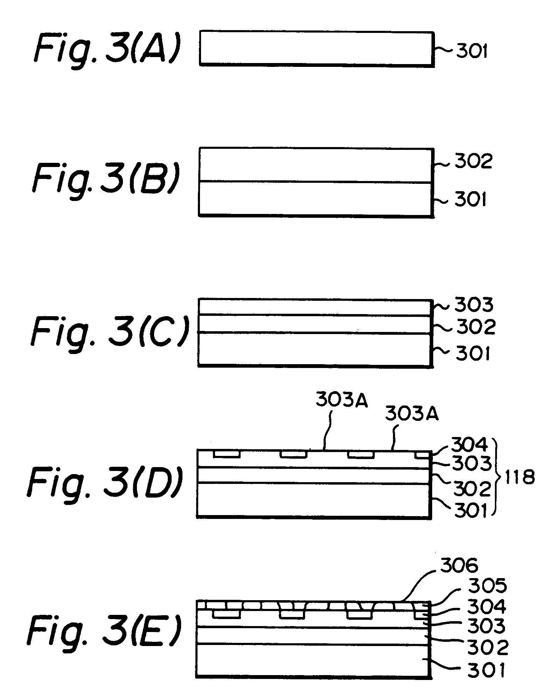

The substrate 118 was prepared according to the steps shown in Fig. 3.

First, a glass base plate 301 of a material having substantially uniform composition as shown in Fig. 3(A) was washed and then an amorphous SiN (A-SiN) thin film 302 was formed with a thickness of about 2 µm on the whole surface of the base plate 301 (Figure 3(B)) by means of thermal CVD.

Subsequently, surface annealing of the above A-SiN thin film 302 was effected in N₂ atmosphere by means of a laser annealing device on the A-SiN thin film 302 to form crystalline Si₃N₄ (C-Si₃N₄) 303 in the surface layer (up to 1 µm deep of the A-SiN thin film 302 to 1 µm (Figure 3(C)).

As the laser used at this time, Ar-CW laser of 488 nm (4880 Å), a scanning speed of 2.5 cm/sec and an energy of 10 W was irradiated. Subsequently, the surface of the C-Si₃N₄ layer 303 was scanned by means of the above laser annealing device in O₂ atmosphere to form selectively the SiO₂ layer 304 (Figure 3(D)).

According to the steps as described above, a substrate 118 having C-Si₃N₄ layer 303A exposed at constant intervals with other portions being covered with SiO₂ layer 304 was formed. The domains of C-Si₃N₄ layer 303A exposed on the substrate surface were about 300 µm in width with intervals of 200 µm therebetween.

Further, by use of this substrate 118, crystalline silicon was deposited by means of the device shown in Fig. 1 similarly as described in Example 1.

First, the vacuum chamber 120 was evacuated under sufficient baking by means of an evacuation device not shown to 7 x 10⁻⁷ Pa (5 x 10⁻⁹ Torr). SiH₄ gas filled in the bomb 101 was permitted to flow for 0.3 sec at a flow rate of 5 sccm into the vacuum chamber 120 through the gas introducing pipe 109 under the state maintained at an evacuation speed of 10⁻² Pals (0.1 m Torr/sec) by controlling the evacuating valve 119. Subsequently, the valve 101d was closed to stop feeding of the SiH₄ gas, and the evacuation valve 119 was opened and the state controlled to a vacuum degree of 13 Pa (0.1 Torr) was maintained for 2 sec.

F₂ gas (diluted to 10 % with He) filled in the bomb 107 was introduced at 6 sccm through the gas introducing pipe 111 into the vacuum chamber 120. The evacuation rate at this time was made 10² Pa/s (0.8 m Torr/sec) by controlling the evacuation valve 119, and after this state was maintained for 5 sec, the valve 107a was closed to stop feeding of the F₂ gas, and the state controlled to vaccum of 1 Pa (0.01 Torr) was maintained for 4 sec by opening the evacuation valve 119.

By repeating this operation for 4500 times, a crystalline silicon deposited film with a thickness of about 2.3 µm was obtained.

Fig. 3(F) shows schematically the cross-section of the crystalline silicon deposited film 305 obtained on the substrate 118. 306 denotes grain boundaries in Fig. 3(F).

Further, by use of the respective samples obtained, crystallinity of the deposited films was evaluated by the X-ray diffraction method and the electron beam diffraction method, whereby they were confirmed to be polycrystalline silicon films. Further, the grain size of the polycrystalline silicon determined by the Scherrar method was found to be about 120±25 µm. Variance in crystal grain sizes was uniform over the whole surface of the substrate.

When the surface state of the sample was observed by a scanning type electron microscope, the smoothness was good without wavy pattern, etc., and the film thickness irregularity was ±4 % or less. Also, the mobility and conductivity of the crystalline Si deposited film of the obtained samples was measured by the Van der Pauw method to be 120 (cm/V sec), 9 x 10⁻⁶ (S cm⁻¹), respectively.

### Example 3

By means of the film forming device shown in Fig. 1, a deposited film according to the method of the present invention was prepared as described below.

SiH₄ gas filled in the bomb 101 was fed at a flow rate of 40 sccm through the gas introducing pipe 109, F₂ gas filled in the bomb 106 at a flow rate of 60 sccm and the He gas filled in the bomb 107 at a flow rate 120 sccm through the gas introducing pipe 111 into the vacuum chamber 120. In this Example, the bubblers 126 and 127 for liquid starting materials were not used.

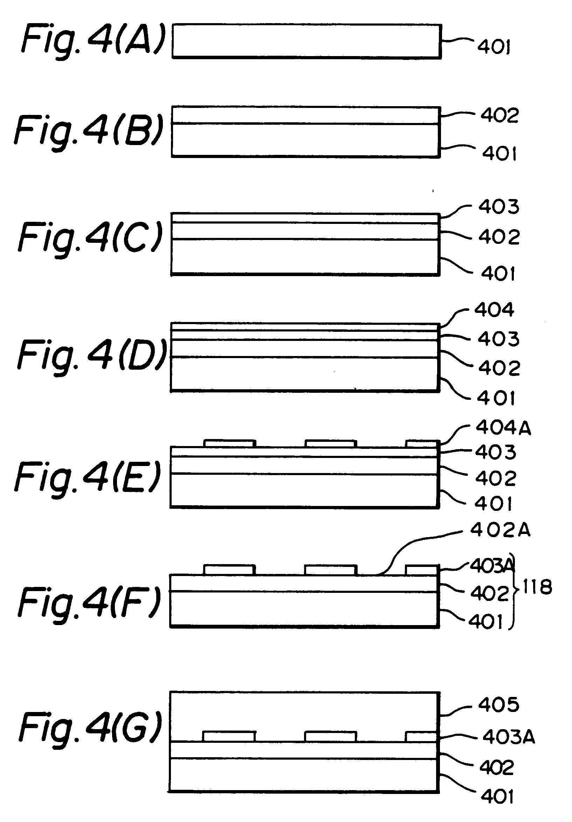

The substrate 118 was prepared according to the steps shown in Fig. 4.

First, a polycrystalline silicon substrate 401 as shown in Fig. 4(A) was washed, and subsequently amorphous SiO₂ thin film 402 was deposited on the whole surface of the substrate 401 according to the sputtering method (in this step other various thin film depositing methods such as vacuum vapor deposition, plasma discharging, MBE, CVD, etc., may be employed) Figure 4(B)). Then, amorphous Si₃N₄ thin film 403 was deposited on said SiO₂ thin film 402 [Figure 4(C)].

Subsequently, an electron beam resist layer 404 was formed on the thin film 403 [Figure 4(D)], and the electron beam resist layer 404 exposed to light by use of a photomask with a desired pattern and the electron beam resist layer 404 was partially removed by development [Figure 4(E)].

With the use of the remaining electron beam resist layer 404A as the mask, the Si₃N₄ thin film 403 was subjected to etching to form Si₃N₄ thin film 403A with a desired pattern [Figure 4(F)].

According to the steps as described above, a substrate 118 where the surface of the SiO₂ layer 402 was exposed at constant intervals from the Si₃N₄ thin film 402 was obtained. The above Si₃N₄ thin film portions were arranged on the SiO₂ thin film 402 at a width of 200 µm and an interval of 200 µm.

Next, the vaccum chamber 120 was evacuated under sufficient baking by means of an evacuating device not shown to 7 x 10⁻⁷ Pa (5 x 10⁻⁹ Torr). SiH₄ gas filled in the bomb 101 was permitted to flow at a flow rate of 4 sccm through the gas introducing pipe 109 into the vaccum chamber 120 for 0.3 sec under the state maintained at an evacuating speed of 10⁻² Pa/cm (0.1 mTorr/cm) by controlling the evacuating valve 119. Subsequently, the valve 101d was closed to stop feeding of SiH₄ gas, and the state controlled to a vacuum degree of 1 Pa (0.01 Torr) by opening the evacuating valve 119 was maintained for 2 sec.

F₂ gas (diluted to 10% with He) filled in the bomb 107 was introduced at 4 sccm through the gas introducing pipe 111 into the vaccum chamber 120. The evacuation rate at this time was controlled to 10⁻¹ Pa/s (0.8 mTorr/sec) by controlling the evacuating valve 119, and after this state was maintained for 5 sec, the valve 107a was closed to stop feeding of F₂ gas, and the state controlled to a vacuum degree of (0.004 Torr) 5.3 x 10⁻¹ Pa by opening the evacuation valve 119 was maintained for 3 sec.

By repeating the operation as described above for 10000 times, a crystalline silicon deposited film 405 with a thickness of about 3.0 µm was obtained.

Fig. 4(G) shows schematically the cross-section of the crystalline silicon deposited film 405 obtained on the substrate 118.

Next, by the use of the respective samples obtained, crystallinity of the silicon deposited films was evaluated by the X-ray diffraction method and the electron beam diffraction method, whereby they were confirmed to be polycrystalline silicon films. Further, the grain size of the polycrystalline silicon determined by the Scherrar method was found to be about 40 ± 0.5 µm. Variance in crystal grain sizes was uniform over the whole surface of the substrate.

When the surface state of the samples was observed by a scanning type electron microscope, the smoothness was good without wavy pattern, etc., and the film thickness irregularity t was ±4% or less. Also, the mobility and conductivity of the crystalline Si deposited film of the obtained samples was measured by the Van der Pauw method to be 300 (cm/V sec), 9 x 10⁻⁶ (S cm⁻¹), respectively.

### Example 4

The substrate 118 was prepared according to the steps shown in Fig. 4.

First, a glass base plate 401 of a material having substantially uniform composition as shown in Fig. 4(A) was washed and then an amorphous SiN:H thin film 402 was formed using SiH₄ gas and NH₃ gas with a thickness of about 2 µm on the whole surface of the base plate 401 [Figure 3(B)] by means of plasma CVD.

Subsequently, an amorphous SiO₂ thin film 404 was formed 50 nm (500 Å) thick on the above SiN:H thin film 402 by means of the sputtering method [Figure 4(C)].

Then, an electron beam resist layer 404 was applied onto the SiO₂ thin film 403 [Figure 4(D)], and the electron beam resist layer 404 was exposed with the use of a photomask having a desired pattern followed by partial removal of the electron beam resist layer 404 by development [Figure 4(E)]. The SiO₂ layer 403 was then subjected to etching to form an SiO₂ layer 403A having a desired pattern with utilizing the remaining electorn beam resist layer 404A as a mask.

According to the steps as described above, a substrate 118 having domains 402A where the Si₃N₄ layer 402 was exposed at constant intervals with other portions being covered with SiO₂ layer 403A was formed. The domains of Si₃N₄ layer 402A exposed on the substrate surface were about 300 µm in width with intervals of 280 µm therebetween.

Further, by use of this substrate 118, crystalline silicon was deposited by means of the device shown in Fig. 1 similarly as described in Example 3.

First, the vacuum chamber 120 was evacuated under sufficient baking by means of an evacuation device not shown to 7 x 10⁻⁷ Pa (5 x 10⁻⁹ Torr). SiH₄ gas filled in the bomb 101 was permitted to flow for 0.3 sec at a flow rate of 5 sccm into the vacuum chamber 120 through the gas introducing pipe 109 under the state maintained at an evacuation speed of (0.1 mTorr/sec) 1.3 x 10⁻² Pa/s by controlling the evacuating valve 119. Subsequently, the valve 101d was closed to stop feeding of the SiH₄ gas, and the evacuation valve 119 was opened and the state controlled to a vacuum degree of 13 Pa (0.1 Torr) was maintained for 2 sec.

F₂ gas (diluted to 10% with He) filled in the bomb 107 was introduced at 6 sccm through the gas introducing pipe 111 into the vacuum chamber 120. The evacuation rate at this time was made 10⁻¹ Pa/s (0.8 mTorr/sec) by controlling the evacuation valve 119, and after this state was maintained for 5 sec, the valve 107a was closed to stop feeding of the F₂ gas, and the state controlled to vacuum of 1 Pa (0.01 Torr)was maintained for 4 sec by opening the evacuation valve 119.

By repeating this operation for 7000 times, a crystalline silicon deposited film with a thickness of about 2.8 µm was obtained.

Fig. 4(G) shows schematically the cross-section of the crystalline silicon deposited film 405 obtained on the substrate 118.

Further, by use of the respective samples obtained, crystallinity of the deposited films was evaluated by the X-ray diffraction method and the electron beam diffraction method, whereby they were confirmed to be polycrystalline silicon films. Further, the grain size of the polycrystalline silicon was found to be about 90 ± 7 µm. Variance in crystal grain sizes was uniform over the whole surface of the substrate.

When the surface state of the sample was observed by a scanning type electron microscope, the smoothness was good without wavy pattern, etc., and the film thickness irregularity was ±4% or less. Also, the mobility and conductivity of the crystalline Si deposited film of the obtained samples was measured by the Van der Pauw method to be 120 (cm/V sec), 4 x 10⁻⁶ (S cm⁻¹), respectively.

The method for forming a deposited film of the present invention can form a deposited film only by contacting a gaseous starting material with a gaseous halogenic oxidizing agent, and has the advantage of requiring particularly no reaction exciting energy from the outside. Accordingly, it becomes possible to lower the substrate temperature. Also, since a material which becomes the crystal nucleus for the deposited film or capable of forming selectively the crystal nucleus can be arranged at a desired position on the substrate surface, any desired crystalline deposited film can be formed. Further, simultaneously with saving of energy, it is possible to obtain a crystalline deposited film having uniform film quality and characteristics over a large area with easy control of the film quality. Further, a crystalline film excellent in productivity, bulk productivity and having high quality with excellent electrical, optical semiconductive and other physical properties can be obtained with ease.

## Claims

1. A method for forming crystalline film on the surface of a substrate, which method comprises:
introducing a first gaseous material into a film forming space containing the substrate, and adsorbing an amount of said first gaseous material at the surface of said substrate;
removing a surplus amount of said first gaseous material while retaining a sufficient amount of said first gaseous material adsorbed at the surface of said substrate;
introducing a second gaseous material into said film forming space and reacting this with said sufficient amount of said first-gaseous material adsorbed at the surface of said substrate to form the crystalline film; and
which method is characterised in that:
the surface of said substrate either has, provided at the outset, at scattered sites thereof, a multiplicity of single-crystalline grains for seeding growth of the crystalline film or has regions which differ in their respective propensity for nucleating film material for growth of the crystalline film;
the first and second gaseous materials are one and the other of:
a gaseous starting material containing a major constituent of the film to be formed, and
a gaseous halogenic oxidising agent having the property of oxidative action on said gaseous starting material; and
flow rates of said first and second gaseous materials and temperatures and pressures during adsorption and reaction are appropriately chosen such that said reacting of said first and second gaseous materials results in the growth of film in a poly-crystalline form.

2. A method according to claim 1, wherein it is the gaseous halogenic oxidising agent that is adsorbed onto the substrate surface.

3. A method according to claim 1, wherein it is the gaseous starting material that is adsorbed onto the substrate surface.

4. A method according to any preceding claim, wherein the steps of: introducing said first gaseous material; removing said surplus amount of first gaseous material; and introducing said second material, are performed repeatedly following a step of removing any surplus amount of said second gaseous material and any surplus reaction products.

5. A method according to any preceding claim, wherein the gaseous starting material is a chain silane compound.

6. A method according to claim 5, wherein the chain silane compound is a straight chain silane compound.

7. A method according to claim 6, wherein the straight chain silane compound is represented by the formula SiₙH₂ₙ₊₂ wherein n is an integer of 1 to 8.

8. A method according to claim 5, wherein the chain silane compound is a branched chain silane compound.

9. A method according to any of claims 1-4, wherein said gaseous starting material is a cyclic silane compound.

10. A method according to any preceding claim, wherein the gaseous halogenic oxidising agent comprises a halogen gas.

11. A method according to claim 10, wherein the gaseous halogenic oxidising agent comprises fluorine gas.

12. A method according to claim 10, wherein the gaseous halogenic oxidising agent comprises chlorine gas.

13. A method according to claim 10, wherein the gaseous halogenic oxidising agent is a gas containing fluorine atoms.

14. A method claimed in any preceding claim wherein the adsorption step is carried out at a pressure of 1 x 10⁻⁴ to 1 Torr (1.3 x 10⁻² to 1.3x10² Pa).

15. A method according to claim 14, wherein the pressure in the reaction space is reduced to 1 x 10⁻⁹ to 1 x 10⁻² Torr (1.3 x 10⁻⁷ to 1.3 Pa) to discharge superfluous first gaseous material before introduction of the second gaseous material.

16. A method according to claim 14 or 15, wherein the pressure in the reaction space during the reaction of the first and second gaseous materials is 1 x 10⁻⁶ to 1 Torr (1.3 x 10⁻² to 1.3x10² Pa).

17. A method according to any preceding claim wherein the surface of said substrate is that having said regions which differ in their propensity for nucleating film material for growth of the crystalline film, these regions being previously formed in a pattern by first depositing on the surface of the substrate a layer of material having a different propensity for nucleating said film material, covering said layer of material with a layer of electron beam resist, exposing said resist layer to light using a patterned photomask, developing said resist layer, transferring the pattern of the developed resist layer to the underlying deposited layer by etching to reveal regions of the underlying substrate surface, and removing the remaining resist material.

18. A method according to any preceding claim 1 to 16 wherein the surface of said substrate is that having said regions which differ in their propensity for nucleating film material for growth of the crystalline film, these regions being formed in a pattern by providing a crystalline silicon nitride layer at the surface of the substrate and annealing this by laser scanning in an oxygen atmosphere to form regions of silica among regions of said crystalline silicon nitride.

19. A method according to claim 1, wherein said regions are of different composition.

20. A method according to claim 19, as applied to the growth of poly-crystalline silicon film, wherein said regions of different composition comprise:
regions of polycrystalline silicon and regions of silicon oxide; or
regions of silicon oxide and silicon nitride.

## Patentansprüche

1. Verfahren zur Bildung eines kristallinen Films auf einer Substratoberfläche, bei dem man
ein erstes gasförmiges Material in einen das Substrat enthaltenden Filmbildungsraum einführt und eine Menge des ersten gasförmigen Materials an der Oberfläche des Substrats adsorbiert,
eine Überschußmenge des ersten gasförmigen Materials entfernt, während eine genügende Menge des ersten gasförmigen Materials an der Substratoberfläche absorbiert bleibt,
ein zweites gasförmiges Material in den Filmbildungsraum einführt und mit der an der Substratoberfläche adsorbierten genügenden Menge des ersten gasförmigen Materials unter Bildung des kristallinen Films umsetzt,
dadurch gekennzeichnet, daß
die Substratoberfläche entweder zu Beginn an verteilten Stellen eine Vielzahl einkristalliner Körner für das Keimwachstum des kristallinen Films hat oder aber Bereiche aufweist, die sich in ihrer Neigung zur Keimbildung von Filmmaterial für das Wachstum des kristallinen Films unterscheiden,
das erste und das zweite gasförmige Material das eine und das andere von
einem einen Hauptbestandteil des zu bildenden Films enthaltenden gasförmigen Ausgangsmaterial und
einem gasförmigen, halogenhaltigen Oxidationsmittel ist, das die Eigenschaft der oxidativen Einwirkung auf das gasförmige Ausgangsmaterial hat, und
die Strömungsgeschwindigkeiten des ersten und des zweiten Ausgangsmaterials, die Temperaturen und die Drucke während der Adsorption und Reaktion so in geeigneter Weise ausgewählt werden, daß die Umsetzung des ersten und zweiten gasförmigen Materials zu dem Wachstum des Films in polykristalliner Form führt.

2. Verfahren nach Anspruch 1, bei dem auf der Substratoberfläche das gasförmige halogenhaltige Oxidationsmittel adsorbiert ist.

3. Verfahren nach Anspruch 1, bei dem auf der Substratoberfläche das gasförmige Ausgangsmaterial adsorbiert ist.

4. Verfahren nach einem der vorhergehenden Ansprüche, bei dem die Stufen der Einführung des ersten gasförmigen Materials, der Entfernung der Überschußmenge des ersten gasförmigen Materials und der Einführung des zweiten Materials wiederholt durchgeführt werden mit dann folgender Stufe der Entfernung einer jeglichen Überschußmenge des zweiten gasförmigen Materials und jeglicher überschüssiger Reaktionsprodukte.

5. Verfahren nach einem der vorhergehenden Ansprüche, bei dem das gasförmige Ausgangsmaterial eine kettenförmige Silanverbindung ist.

6. Verfahren nach Anspruch 5, bei dem die kettenförmige Silanverbindung eine geradkettige Silanverbindung ist.

7. Verfahren nach Anspruch 6, bei dem die geradkettige Silanverbindung durch die Formel SiₙH₂ₙ₊₂ dargestellt wird, worin n eine ganze Zahl von 1 bis 8 ist.

8. Verfahren nach Anspruch 5, bei dem die kettenförmige Silanverbindung eine verzweigtkettige Silanverbindung ist.

9. Verfahren nach einem der Ansprüche 1 bis 4, bei dem das gasförmige Ausgangsmaterial eine cyclische Silanverbindung ist.

10. Verfahren nach einem der vorhergehenden Ansprüche, bei dem das gasförmige halogenhaltige Oxidationsmittel ein Halogengas umfaßt.

11. Verfahren nach Anspruch 10, bei dem das gasförmige halogenhaltige Oxidationsmittel Fluorgas umfaßt.

12. Verfahren nach Anspruch 10, bei dem das gasförmige halogenhaltige Oxidationsmittel Chlorgas umfaßt.

13. Verfahren nach Anspruch 10, bei dem das gasförmige halogenhaltige Oxidationsmittel ein Fluoratome enthaltendes Gas ist.

14. Verfahren nach einem vorhergehenden Anspruch, bei dem die Adsorptionsstufe bei einem Druck von 1 x 10⁻⁴ bis 1 Torr (1,3 x 10⁻² bis 1,3 x 10² Pa) durchgeführt wird.

15. Verfahren nach Anspruch 14, bei dem der Druck in dem Reaktionsraum auf 1 x 10⁻⁹ bis 1 x 10⁻² Torr (1,3 x 10⁻⁷ bis 1,3 Pa) verringert wird, um vor der Einführung des zweiten gasförmigen Materials das überflüssige erste gasförmige Material auszutragen.

16. Verfahren nach Anspruch 14 oder 15, bei dem der Druck in dem Reaktionsraum während der Umsetzung des ersten und zweiten gasförmigen Materials 1 x 10⁻⁶ bis 1 Torr (1,3 x 10⁻² bis 1,3 x 10² Pa) beträgt.

17. Verfahren nach einem vorhergehenden Anspruch, bei dem die Substratoberfläche Bereiche hat, die sich in ihrer Neigung zur Keimbildung von Filmmaterial für das Wachstum kristalliner Filme unterscheiden, wobei diese Bereiche vorher in einem Muster dadurch gebildet wurden, daß man zuerst auf der Substratoberfläche eine Materialschicht mit unterschiedlicher Neigung zur Keimbildung des genannten Filmmaterials abscheidet, die genannte Materialschicht mit einer Elektronenstrahl-Resistschicht bedeckt, die Resistschicht unter Benutzung einer musterförmigen Photomaske belichtet, die Resistschicht entwickelt, das Muster der entwickelten Resistschicht durch Ätzen auf die darunter liegende abgeschiedene Schicht überträgt, um Bereiche der darunter liegenden Substratoberfläche freizulegen, und das verbliebene Resistmaterial entfernt.

18. Verfahren nach einem der vorhergehenden Ansprüche 1 bis 16, bei dem die Substratoberfläche die genannten Bereiche hat, die sich in ihrer Neigung zur Keimbildung des Filmmaterials für das Wachstum des kristallinen Films unterscheiden, wobei diese Bereiche in einem Muster dadurch gebildet werden, daß man an der Substratoberfläche eine kristalline Siliziumnitridschicht vorsieht und diese durch Laserabtastung in einer Sauerstoffatmosphäre tempert, um Siliziumdioxid-Bereiche innerhalb von Bereichen aus dem genannten kristallinen Siliziumnitrid zu bilden.

19. Verfahren nach Anspruch 1, bei dem die genannten Bereiche unterschiedliche Zusammensetzung haben.

20. Verfahren nach Anspruch 19 bei Anwendung auf das Wachstum von polykristallinen Siliziumfilmen, wobei die genannten Bereiche unterschiedlicher Zusammensetzung
Bereiche aus polykristallinem Silizium und Bereiche aus Siliziumoxid oder
Bereiche aus Siliziumoxid und Siliziumnitrid umfassen.

## Revendications

1. Procédé de formation d'un film cristallin sur la surface d'un substrat, procédé qui consiste :
à introduire une première matière gazeuse dans un espace de formation de film contenant le substrat, et à provoquer l'adsorption d'une quantité de ladite première matière gazeuse à la surface dudit substrat ;
à éliminer une quantité en excès de ladite première matière gazeuse tout en maintenant une quantité suffisante de ladite première matière gazeuse adsorbée à la surface dudit substrat ;
à introduire une seconde matière gazeuse dans ledit espace de formation de film et à faire réagir cette matière avec ladite quantité suffisante de ladite première matière gazeuse adsorbée à la surface dudit substrat pour former le film cristallin ;
ledit procédé étant caractérisé en ce que :
la surface dudit substrat possède, placés au début, au niveau de ses sites de dispersion, un grand nombre de grains monocristallins pour déclencher par la présence de germes la croissance du film cristallin, ou bien possède des régions qui diffèrent par leur tendance respective à la nucléation d'une matière de formation de film pour la croissance du film cristallin ;
les première et seconde matières gazeuses sont constituées l'une et l'autre :
d'une matière gazeuse de départ contenant un constituant dominant du film à former, et
d'un agent halogéné gazeux oxydant doué d'une action oxydative sur ladite matière gazeuse de départ ; et
les débits desdites première et seconde matières gazeuses et les températures et les pressions au cours de l'adsorption et de la réaction sont choisis de manière appropriée, de telle sorte que ladite réaction desdites première et seconde matières gazeuses ait pour résultat la croissance d'un film sous forme polycristalline.

2. Procédé suivant la revendication 1, caractérisé en ce que l'agent halogéné gazeux oxydant est adsorbé sur la surface du substrat.

3. Procédé suivant la revendication 1, caractérisé en ce que la matière gazeuse de départ est adsorbée sur la surface du substrat.

4. Procédé suivant l'une quelconque des revendications précédentes, dans lequel les étapes : d'introduction de la première matière gazeuse ; d'élimination de la quantité en excès de première matière gazeuse ; et d'introduction de la seconde matière sont mises en oeuvre à plusieurs reprises après une étape d'élimination de toute quantité en excès de ladite seconde matière gazeuse et de n'importe quels produits de réaction en excès.

5. Procédé suivant l'une quelconque des revendications précédentes, dans lequel la matière gazeuse de départ est un silane en chaîne.

6. Procédé suivant la revendication 5, dans lequel le silane en chaîne est un silane à chaîne droite.

7. Procédé suivant la revendication 6, dans lequel le silane à chaîne droite est représenté par la formule SiₙH₂ₙ₊₂ dans laquelle n représente un nombre entier de 1 à 8.

8. Procédé suivant la revendication 5, dans lequel le silane en chaîne est un silane à chaîne ramifiée.

9. Procédé suivant l'une quelconque des revendications 1 à 4, dans lequel la matière gazeuse de départ est un silane cyclique.

10. Procédé suivant l'une quelconque des revendications précédentes, dans lequel l'agent halogéné gazeux oxydant comprend un halogène gazeux.

11. Procédé suivant la revendication 10, dans lequel l'agent halogéné gazeux oxydant comprend du fluor gazeux.

12. Procédé suivant la revendication 10, dans lequel l'agent halogéné gazeux oxydant comprend du chlore gazeux.

13. Procédé suivant la revendication 10, dans lequel l'agent halogéné gazeux oxydant est un gaz contenant des atomes de fluor.

14. Procédé suivant l'une quelconque des revendications précédentes, dans lequel l'étape d'adsorption est mise en oeuvre sous une pression de 1 x 10⁻⁴ à 1 torr (1,3 x 10⁻² à 1,3 x 10² Pa).

15. Procédé suivant la revendication 14, dans lequel la pression dans l'espace réactionnel est réduite à une valeur comprise dans l'intervalle de 1 x 10⁻⁹ à 1 x 10⁻¹² torrs (1,3 x 10⁻⁷ à 1,3 Pa) pour décharger la première matière gazeuse superflue avant introduction de la seconde matière gazeuse.

16. Procédé suivant la revendication 14 ou 15, dans lequel la pression dans l'espace réactionnel au cours de la réaction des première et seconde matières gazeuses est comprise dans l'intervalle de 1 x 10⁻⁶ à 1 torr (1,3 x 10⁻² à 1,3 x 10² Pa).

17. Procédé suivant l'une quelconque des revendications précédentes, dans lequel la surface du substrat est celle comprenant les régions qui diffèrent par leur tendance à la nucléation de la matière de formation de film pour la croissance du film cristallin, ces régions étant formées préalablement suivant un motif en déposant tout d'abord sur la surface du substrat une couche de matière ayant une tendance différente à la nucléation de ladite matière de formation de film, en recouvrant ladite couche de matière avec une couche d'un agent de réserve sensible à un faisceau d'électrons, à exposer à la lumière ladite couche d'agent de réserve au moyen d'un photomasque muni d'un motif, à développer ladite couche d'agent de réserve, à transférer le motif de la couche d'agent de réserve développée à la couche déposée sous-jacente par gravure pour révéler des régions de la surface du substrat sous-jacent ; et à éliminer l'agent de réserve restant.

18. Procédé suivant l'une quelconque des revendications 1 à 16 précédentes, dans lequel la surface du substrat est celle comprenant les régions qui diffèrent par leur tendance à la nucléation d'une matière de formation de film pour la croissance du film cristallin, ces régions étant formées suivant un motif par formation d'une couche de nitrure de silicium cristallin à la surface du substrat et recuit de cette couche par balayage par laser dans une atmosphère d'oxygène pour former des régions de silice parmi des régions dudit nitrure de silicium cristallin.

19. Procédé suivant la revendication 1, dans lequel les régions possèdent des compositions différentes.

20. Procédé suivant la revendication 19, appliqué à la croissance d'un film de silicium polycristallin, dans lequel les régions de compositions différentes comprennent :
des régions de silicium polycristallin et des régions d'oxyde de silicium ; ou
des régions d'oxyde de silicium et de nitrure de silicium.
